Europäisches Patentamt

European Patent Office

Office européen des brevets

(19)

(11) **EP 0 353 593 B1**

(12) # EUROPEAN PATENT SPECIFICATION

(45) Date of publication and mention
of the grant of the patent:
**03.01.1996 Bulletin 1996/01**

(51) Int Cl.[6]: **G05D 11/13**

(21) Application number: **89113629.3**

(22) Date of filing: **24.07.1989**

(54) **Characteristics control method for aqueous solution**

Verfahren zum Kontrollieren von Eigenschaften einer wässerigen Lösung

Procédé pour le contrôle de caractéristiques d'une solution aqueuse

(84) Designated Contracting States:
**DE NL**

(30) Priority: **01.08.1988 JP 192246/88**

(43) Date of publication of application:
**07.02.1990 Bulletin 1990/06**

(73) Proprietor: **FUJI PHOTO FILM CO., LTD.
Kanagawa (JP)**

(72) Inventor: **Sekiguchi, Naoki
c/o Fuji Photo Film Co., Ltd.
Sizuoka (JP)**

(74) Representative: **Grünecker, Kinkeldey,
Stockmair & Schwanhäusser Anwaltssozietät
D-80538 München (DE)**

(56) References cited:
**DE-B- 2 700 875**          **US-A- 3 678 268**
**US-A- 4 654 802**          **US-A- 4 655 370**

## Description

### Background of the Invention

The present invention relates to a characteristics control method for aqueous solution, and more particularly to a method of controlling a characteristics of a fluid mixture used in surface treatment for a web material such as an aluminum web, a cold-rolled steel web, etc.

One of control systems in combination of feedforward and feedback controls is described in a report entitled "A New Combination of Feedforward and Feedback Controls" in the briefing text delivered on 22nd SICE science lecture meeting, 1983.

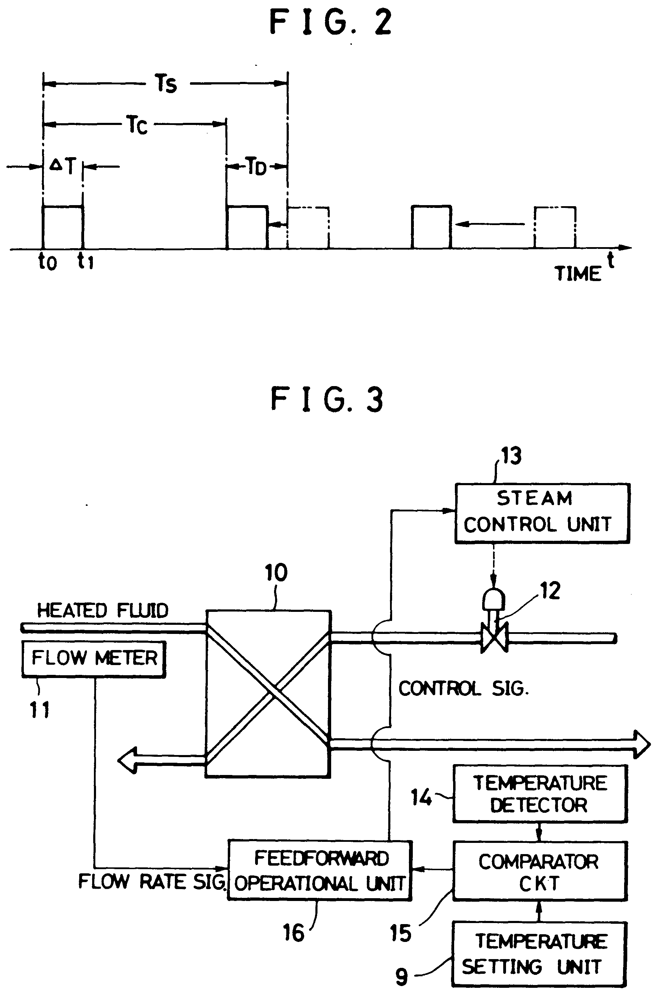

This system is shown in Fig. 3, having a flow meter 11 to meter the rate of flowing fluid into a heat exchanger 10 and provide an appropriate electric signal indicating the detected rate of flow (which is hereinafter referred to as a flow rate signal: FRS). The rate of flow of vapor or steam at a certain temperature which heats the fluid in the heat exchanger 10 is regulated by a controlling valve 12. A steam flow controlling unit 13 changes opening of the controlling valve 12 so as to regulate the rate of flow of the steam. A thermometer 14 detects a temperature of the heated fluid discharged from the heat exchanger 10 to provide an appropriate electric signal (which is hereinafter referred to a temperature signal: TS). The temperature of the heated fluid detected by the thermometer 14 is compared with a reference temperature previously set by a temperature setting unit 9 in a comparison circuit 15. A feedforward operator 16 calculates an appropriate rate of steam based on the result of the comparison of temperature in the comparator curcuit 15 so as to provide the steam flow controlling unit 13 with a signal either for increasing the rate of flow of the steam when the detected temperature is lower than the reference temperature or for decreasing it when the detected temperature is higher than the reference temperature. Because of the fact that the change of the rate of flow of the steam depends upon the change of the amount of heat which the heated fluid has received, a closed loop is formed for feedback control. The feedforward operator 16 receives the flow rate signal FRS from the flow meter 11 and it performs an analog calculation based on the flow rate of the heated fluid so as to provide the steam flow controlling unit 13 with a signal either for increasing the flow rate of the steam when the detected flow rate of the heated fluid is small or for decreasing it when the detected flow rate of the heated fluid is great.

In the above-noted control system, because the feedforward operator 16 performs an analog operation and data for the analog operation is measured before the analog operation, it is hard to perform real-time operations. On the other hand, in a treating apparatus for treating uniformly the whole length of a continuously moving web in a direction in which it is driven, it is inavoidable that a treating vessel or tank containing a liquid mixture or aqueous solution for treating a surface of the web with chemical reaction is long in the moving direction. This leads to a relatively long delay of time in controlling the treating solution. Therefore, it results in a lack of stability in controlling characteristics of aqueous solution to apply the control system in which a solution is not controlled in real-time based on measured data to the treating apparatus which is generally associated with a relatively long delay of time in controlling the treating solution.

It is, therefore, the object of the present invention to provide an improved method of controlling the characteristics of an aqueous solution in a surface treatment system for webs which is quick.

This object is solved by a method of controlling characteristics of an aqueous solution for treating a surface of a continuously moving Hweb having the features of claim 1.

The method of controlling the characteristics of a solution consists of changing the characteristics, such as a specific gravity, of a aqueous solution at a basic period depending upon physical quantities, such as a speed at which the web is driven, and/or the width of the web, in feedforward control and changing the basic period in accordance with a difference between a measured characteristics of the aqueous solution and a reference property value at which the aqueous solution is to be controlled in feedback control.

When the speed and or/ the width of the web is measured, the basic period $T_S$ is determined at which a controlled characteristic of a aqueous solution is effected by, for example, supplying an additive into the aqueous solution. The basic period $T_S$ is increasingly changed if a measured characteristic of the controlled aqueous solution is larger than a reference characteristic which is suitably predetermined for the surface treatment of the web or decreasingly changed if the measured characteristics is smaller than the reference characteristics.

For changing the fundamental period $T_S$ either increasingly or decreasingly, a correction or value $T_D$ determined in accordance with the difference between the measured and the reference characteristics is used to obtain a practical control period $T_C$ from the following equation:

$$T_C = T_S - T_D$$

where the correction or value $T_D$ takes a plus or a minus value.

Because the above characteristics' control is effected periodically, no delay of time in controlling the characteristics of the aqueous solution is caused by effecting feedback control between the periodical controls. Accordingly, a stable, quick control of the characteristics of a solution is effected at low cost without the aid of microcomputer or the like even though the web changes in speed or different widths of webs are alternatively treated.

## Brief Description of the Drawings

Figure 1 is a schematic illustration, partly in block, showing an apparatus embodying a method of controlling characteristics of aqueous according to the present invention;

Figure 2 is a graph showing a period at which an additive is supplied into a solution to be controlled; and

Figure 3 is a schematic block diagram showing an apparatus for heat exchanging in a conventional combination of feedforward and feedback controls.

## Detailed Description of the Invention

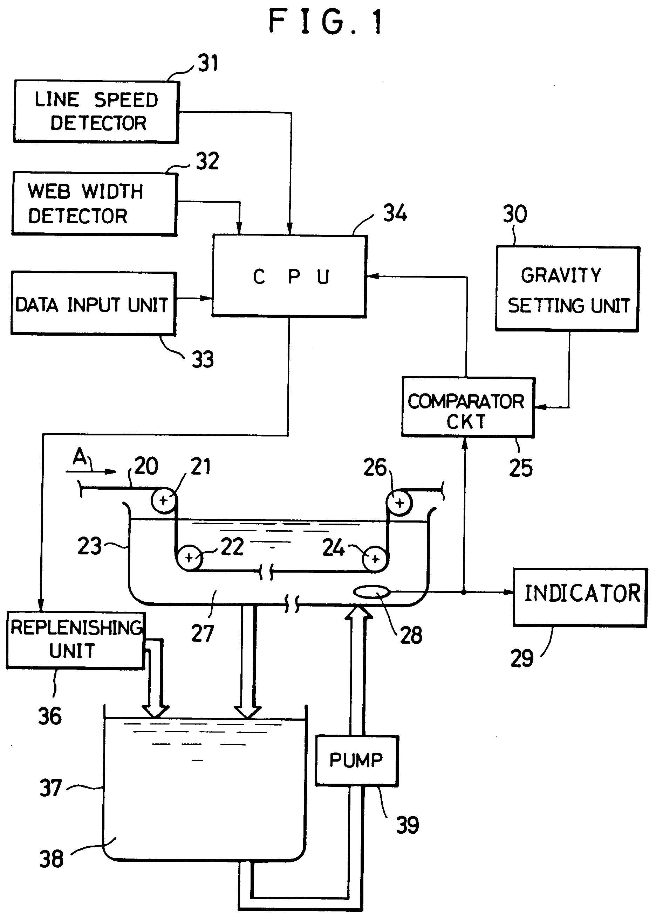

Referring to the drawings, in particular to Fig. 1, showing a preferred embodiment of the present invention, a web 20 such as made of a metal material travels in a direction shown by an arrow A in Fig. 1 at a constant speed. Two pairs of vertically displaced pass rollers 21-22 and 24-26 are oppositely disposed inside a treating vessel or tank 23 and a lower pass rollers 22, 24 of each pair is in a circulating treatment liquid mixture or solution 27 contained in the processing tank 23 so as to form a passage of the metal web 20 partly in the circulating aqueous solution 27. When the metal web 20 passes through the liquid solution, both surface of the metal web 20 is treated with the aqueous solution 27 with chemical reaction.

A specific gravity sensor 28, which is disposed near the bottom of the treating tank 23, constantly monitors the circulating aqueous solution 27 to verify its specific gravity as one of the characteristics of the circulating aqueous solution 27. An indicator 29 displays the specific gravity verified by the specific gravity sensor 28. A comparator circuit 25 compares the verified specific gravity with a reference specific gravity set by a reference specific gravity setting unit 30 and provides a CPU 34 with an output indicating a deviation of the two specific gravities.

A line speed sensor 31 constantly monitors the metal web 20 to verify its line speed and outputs an appropriate electric signal (which is hereinafter referred to a line speed signal: LSS). A width sensor 32 constantly monitors the metal web 20 to verify its width speed and outputs an appropriate electric signal (which is hereinafter referred to a width signal: WS). A data input unit 33 provides a data signal indicating the necessary specific characters such as the kind of the web 20, etc. These signals are all sent to the CPU 34. Based on the line speed, the width and/ other phisical quantities of the metal web 20 and the deviation of the specific gravity of the circulating treating solution 27 from the reference specific gravity, the CPU 34 controls a frequency at which pulses are generated thereby.

A replenishing unit 36 adds a predetermined quantity of liquid additive to replenish aqueous solution 38 in a reservoir 37 every time the pulse is applied thereto from the CPU 34. The aqueous solution 38 is completely mixed with the added liquid additive in a well known manner. The aqueous solution 38 is pumped into the treating tank 23 by a pump 39. To hold the volume of the circulating aqueous solution 27 in the treating tank 23 constant, the circulating aqueous solution 27 is refluxed from the treating tank 23 at the same rate as the delivering rate of the aqueous solution 38 into the treating tank 23. This reflux or replenishment can be taken in any manner well known in the chemical processing art.

The CPU 34 provides a pulse, which pulse has a pulse width T defined between a time $t_0$ at which the pulse rises up and a time at a time $t_1$ at which the pulse falls down. The pulse width T is a measurement of how long the replenishing unit 36 is kept open. The pulse width T is desired to kept constant if the pressure P of the liquid additive is constant or to vary in inverse proportion to a value of $P^{1/2}$ if the pressure fluctuates.

The current period $T_C$ at which the control pulse CP is provided is given as follows:

$$T_C = T_S - T_D$$

where $T_S$ is a fundamental period; and

$T_D$ is a compensatory period depending on the verified specific gravity of the circulating aqueous solution 27.

These periods $T_C$, $T_S$ and $T_D$ are given by the following equations (1), (2) and (3), respectively:

$$T_C = aW - bV + c \tag{1}$$

$$T_S = d(D - D_s) + e \tag{2}$$

$$T_D = T_S - T_D$$

$$= aW - bV - d(D - D_s) + c - e \tag{3}$$

where W is the width of the metal web;

V is the verified line speed of the metal web;
D is the verified specific gravity of the circulating aqueous solution;
$D_s$ is the reference specific gravity; and
a, b, c d and e are invariables according to the properties of the web.

These invariables a, b, c, d and e are experimentally obtained and data of which are stored in the CPU 34.

If any one of the line speed V and the width W of the web 20 and the web 20 itself (the invariables a to d) changes, the fundamental period $T_S$, and accordingly the current period $T_C$ and the compensatory period $T_D$, change according to the equations (1) and (3). That is, if the line speed V intermittently changes while no change of the specific gravity of the circulating aqueous solution 27 causes, the current period $T_C$ immediately changes correspondingly to the changed fundamental period $T_S$ in feedforward control. By means of this feedforward control, the replenishing unit 36 regulates the rate of flow at which the liquid additive is delivered into the aqueous solution 38. Furthermore, feedback control is realized by a closed loop consisting of the steps of verifying a specific gravity by the specific gravity sensor 28, calculating the deviation of the specific gravity of the circulating aqueous solution from the reference specific gravity, changing the a compensatory frequency $T_D$ depending on the calculated deviation of specific gravity, supplying a liquid additive into a aqueous solution, and changing the specific gravity of aqueous solution 28, looped in this order. In the combination of the feedforward and feedback controls a time necessary to adjust or change a characteristics, such as a specific gravity, a conductivity or the like, of a circulating aqueous solution, is shortened by prolonging or shortening the period $T_C$ at which the control pulse CP is provided.

Although the present invention has been fully described by way of the preferred embodiment thereof with reference to the accompanying drawings, it is to be noted that various changes and modifications are apparent to those skilled in the art. Therefore, unless otherwise these changes and modifications depart from the scope of the present invention, they should be construed as included therein.

## Claims

1. A method of controlling characteristics of an aqueous solution for treating a surface of a continuously moving web comprising the steps of:

   detecting at least one physical quantity of said moving web;

   effecting a feedforward control of changing characteristics of said solution at a fundamental period at which a controlled characteristic is affected depending upon said detected physical quantities of said moving web;

   detecting changed characteristics of said solution under said feedforward control; and

   effecting a feedback control for changing said fundamental period of said feedforward control in accordance with a difference between said detected characteristics and characteristics at which said solution is to be controlled.

2. A method as defined in claim 1, wherein said physical quantity of said web is a speed at which said web is continuously driven.

3. A method as defined in claim 1, wherein said physical quantity of said moving web is a width of said web.

4. A method as defined in claim 1, wherein said physical quantities of said moving web are a speed at which said web is continuously driven and a width of said web.

5. A method as defined in claim 1, wherein said characteristics of said solution is a specific gravity.

6. A method as defined in claim 1, wherein said feedforward control of changing characteristics of said solution is effected to add or replenish an additive into said solution.

7. A method according to one of the foregoing claims,

   **characterized by**

   adding a liquid additive at a controlled rate of flow into aqueous solution so as to change characteristics of said solution in said feedforward control; and

   applying said solution to said aqueous solution which is circulating, so as to keep said circulating aqueous solution at a constant level.

## Patentansprüche

1. Verfahren zum Steuern von Kennwerten einer wäßrigen Lösung zur Behandlung einer Oberfläche einer sich kontinuierlich bewegenden Bahn, mit den Schritten:

   Erfassen mindestens einer physikalischen Größe der sich bewegenden Bahn;
   Bewirken einer Direktsteuerung von sich ändernden Kennwerten der Lösung mit einer Fundamentalperiode, mit der eine gesteuerte Kenngröße beeinflußt wird, in Abhängigkeit von den erfaßten physikalischen Größen der sich bewegenden Bahn;
   Erfassen eines sich unter Einfluß der Direktsteuerung ändernden Kennwertes der Lösung; und
   Bewirken eines Regelvorganges zum Ändern der Fundamentalperiode der Direktsteuerung entsprechend dem Unterschied zwischen dem erfaßten Kennwert und dem Wert, auf den der Kennwert der Lösung zu steuern ist.

2. Verfahren nach Anspruch 1, bei dem die physikalische Größe der Bahn die Geschwindigkeit ist, mit der Bahn kontinuierlich angetrieben wird.

3. Verfahren nach Anspruch 1, bei der die physikalische Größe der sich bewegenden Bahn die Breite der Bahn ist.

4. Verfahren nach Anspruch 1, bei der die physikalischen Größen der sich bewegenden Bahn die Geschwindigkeit, mit der die Bahn kontinuierlich angetrieben wird, und die Breite der Bahn ist.

5. Verfahren nach Anspruch 1, bei der die Kenngröße der Lösung ihr spezifisches Gewicht ist.

6. Verfahren nach Anspruch 1, bei der die Direktsteuerung von sich ändernden Kenngrößen der Lösung bewirkt wird durch Hinzufügen oder Auffüllen eines Zusatzes zu der Lösung.

7. Verfahren nach einem der vorangehenden Ansprüche,
**gekennzeichnet durch** Zusetzen eines flüssiger Zusatzes mit einer gesteuerten Strömungsrate zu der flüssigen Lösung, um so Kennwerte der Lösung bei der Direktsteuerung zu ändern, und Zubringen der Lösung zu der in Umlauf befindlichen wäßrigen Lösung, um so die umlaufende wäßrige Lösung auf einem konstanten Niveau zu halten.

## Revendications

1. Procédé de contrôle des caractéristiques d'une solution aqueuse pour le traitement d'une surface d'un tissu se déplaçant en continu comprenant les étapes consistant :

   à détecter au moins une quantité physique dudit tissu se déplaçant ;
   à réaliser une commande à action directe consistant à modifier les caractéristiques de ladite solution sur une période fondamentale à laquelle on affecte une caractéristique contrôlée dépendant desdites quantités physiques détectées dudit tissu se déplaçant ;
   à détecter les caractéristiques modifiées de ladite solution sous ladite commande à action directe ; et
   à réaliser une commande à rétroaction pour modifier ladite période fondamentale de ladite commande à action directe selon la différence entre lesdites caractéristiques détectées et caractéristiques pour lesquelles ladite solution doit être contrôlée.

2. Procédé selon la revendication 1, dans lequel ladite quantité physique dudit tissu est la vitesse à laquelle ledit tissu se déplace en continu.

3. Procédé selon la revendication 1, dans lequel ladite quantité physique dudit tissu en déplacement est la largeur dudit tissu.

4. Procédé selon la revendication 1, dans lequel lesdites quantités physiques dudit tissu se déplaçant sont la vitesse à laquelle ledit tissu se déplace en continu et la largeur dudit tissu.

5. Procédé selon la revendication 1, dans lequel ladite caractéristique de ladite solution est le poids volumique.

6. Procédé selon la revendication 1, dans lequel ladite commande à action directe consistant à modifier les caractéristiques de ladite solution est réalisée pour ajouter ou introduire un additif dans ladite solution.

7. Procédé selon l'une quelconque des revendications précédentes, caractérisé en ce que

   on ajoute un additif liquide à un débit contrôlé dans la solution aqueuse afin de modifier les caractéristiques de ladite solution dans ladite commande à action directe; et
   on applique ladite solution à ladite solution aqueuse qui est en circulation afin de maintenir ladite solution aqueuse en circulation à un niveau constant.

# FIG. 1

# F I G. 2

# F I G. 3